# EUROPÄISCHE PATENTSCHRIFT

(11) **EP 1 256 151 B1**
(45) Veröffentlichungstag und Bekanntmachung des Hinweises auf die Patenterteilung: **20.07.2005**
(21) Anmeldenummer: 01913546.6
(22) Anmeldetag: 30.01.2001
(51) Int. Cl.: H01S 5/183, H01S 5/026

(54) **VCSEL MIT MONOLITHISCH INTEGRIERTEM PHOTODETEKTOR**
VCSEL WITH MONOLITHICALLY INTEGRATED PHOTODETECTOR
LASER A CAVITE VERTICALE EMETTANT PAR LA SURFACE DOTE D'UN PHOTODETECTEUR A INTEGRATION MONOLITHIQUE

(30) Priorität: 02.02.2000 DE 10004398
(43) Veröffentlichungstag der Anmeldung: 13.11.2002
(73) Patentinhaber: Infineon Technologies AG, 81669 München (DE)
(72) Erfinder: STEINLE, Gunther, 81543 München (DE); WOLF, Hans-Dietrich, 85662 Hohenbrunn (DE)
(74) Vertreter: Epping Hermann & Fischer
(86) Internationale Anmeldenummer: PCT/DE2001/000352
(87) Internationale Veröffentlichungsnummer: WO 2001/057977

(56) Entgegenhaltungen:
- EP-A- 0 565 374
- EP-A- 0 899 836
- US-A- 5 606 572
- US-A- 5 892 786
- ORTIZ G G ET AL: "MONOLITHIC INTEGRATION OF IN0.2GA0.8AS VERTICAL-CAVITY SURFACE- EMITTING LASERS WITH RESONANCE-ENHANCED QUANTUM WELL PHOTODETECTORS" ELECTRONICS LETTERS,IEE STEVENAGE,GB, Bd. 32, Nr. 13, 20. Juni 1996 (1996-06-20), Seiten 1205-1207, XP000599193 ISSN: 0013-5194

## Beschreibung

Die vorliegende Erfindung betrifft VCSEL (Vertical Cavity Surface Emitting Laser) mit einem Photodetektor, der monolithisch in dem Resonator zwischen den Resonatorendspiegeln (DBR-Gitter) integriert ist, für optische Übertragungsstrekken für hohe Datenraten.

Die elektrischen und optischen Eigenschaften, wie z.B. Schwellenstrom und differentieller Wirkungsgrad, variieren bei Laserdioden von Bauelement zu Bauelement. Die Eigenschaften jedes Bauelementes hängen von der Temperatur ab und sind lang- und kurzzeitigen Schwankungen unterworfen. Deshalb ist es erforderlich, über ein elektrisches Rückkoppelsignal zu verfügen, das direkte Informationen über die tatsächliche optische Ausgangsleistung des Lasers liefert und verwendet werden kann, um sowohl die Gleichstromvorspannung (bias) als auch die Modulationstiefe des Laserstromes auch während der Übertragung nachzuregeln. Die mit dem Aufbau einer Vorrichtung zur Einkopplung eines zwar geringen, aber doch bestimmten Anteils der Laserstrahlung in einen externen Photodetektor verbundenen Kosten führten zu der Entwicklung monolithisch integrierter Bauelemente.

Eine Reihe von VCSEL-Strukturen mit monolithisch integrierten Photodetektoren in den als Reflektor fungierenden Bragg-Gittern sind beschrieben in den Veröffentlichungen von T. Kim et al.: "A Single Transverse Mode Operation of Top Surface Emitting Laser Diode with a Integrated photo-diode" in Proc. LEOS 1995, S. 416 - 417, Oktober 1995, von S. F. Lim et al.: "Intracavity Quantum-Well Photodetection of a Vertical-Cavity Surface-Emitting Laser" in Proc. Int. S.C.-Laser Conf. Oktober 1996, Haifa/Israel, S. 183 - 184, and von J. A. Lott et al.: "Deep Red Vertical Cavity Surface Emitting Lasers With Monolithically Integrated Heterojunction Phototransistors For Output Power Control"" in Proc. Int. S.C.-Laser Conf. Oktober 1996, Haifa/Israel, S. 185 - 186. Weitere Quellen sind die Patente US 5,757,837, US 5,742,630, US 5,577,064, US 5,606,572 und US 5,136,603.

In der US 5 606 572 ist ein VCSEL beschrieben, bei dem der aktive Bereich zwischen Spacer-Schichten angeordnet ist und ein Photodetektor in einem der für die Laserresonanz vorgesehenen DBR-Spiegel angeordnet ist. Der Photodetektor umfasst eine undotierte Schicht zwischen n-leitend und p-leitend dotierten Schichtanteilen des betreffenden DBR-Spiegels.

Die veröffentlichten Laserstrukturen mit integrierten Photodetektoren erfüllen nicht alle der folgenden Mindestbedingungen: einfache Herstellbarkeit ohne Ausbeuteverlust auf dem Wafer, guter Kontrast gegenüber spontaner Emission und Umgebungslicht, um sowohl die Laserschwelle als auch den differentiellen Wirkungsgrad feststellen zu können, geringe oder keine zusätzlichen Anforderungen an die anzulegende Spannung für das Gesamtsystem, reproduzierbare und frequenzunabhängige Rückkoppeleigenschaften und nur geringe Änderung der optischen und elektrischen Eigenschaften über lange Betriebszeiten (Deterioration).

Photodetektoren in dem Halbleiterresonator sind praktisch nicht empfindlich gegen Umgebungslicht oder Streulicht. Da die Detektoreigenschaften dieser Photodetektoren vorwiegend auf den Eigenschaften des epitaktischen Schichtwachstums beruhen, kann eine gute Ausbeute funktionsfähiger Bauelemente auch bei einer Fertigung mit großen Toleranzen erzielt werden. Um Bauelemente herzustellen, deren Photodetektoren einen guten Kontrast gegen spontane Emission liefern, kann man entweder den aktiven Detektorbereich auf eine Größe des Laserflecks reduzieren, was aber zusätzliche technische Probleme aufwirft und damit die Ausbeute reduziert (I. Y. Han, Y. H. Lee: "Oxide-apertured photodetector integrated on VCSEL" in Proc. CLEO '99, S. 176); oder die Empfindlichkeit gegenüber dem kohärenten Licht im Vergleich zur spontanen Emission kann durch einen dünnen absorbierenden Bereich an einem Schwingungsbauch der stehenden Welle erhöht werden. Indem man den Abstand dieses dünnen absorbierenden Bereiches von dem aktiven Bereich verringert, kann der Kontrast gegen spontane Emission weiter erhöht werden. Damit wird allerdings auch die Absorption der Laserstrahlung erhöht, so dass der differentielle Wirkungsgrad herabgesetzt wird, was zu sehr hohen Empfindlichkeiten des Detektors von etwa 1A/W führt.

Ein anderes Problem liegt darin, in einem integrierten Bauelement höhere Laserimpedanzen im Vergleich zu einem einzelnen VCSEL und damit Schwierigkeiten bei Verwendung einer Treiberschaltung für hochfrequente Modulation des Laserstromes zu vermeiden. Außerdem muss elektrisches Übersprechen zwischen Laser und Detektor minimiert werden, falls unveränderte HF-Komponenten des Monitorsignales gebraucht werden, z.B. beim Justieren von Gleichstromvorspannung und Modulationstiefe.

Aufgabe der vorliegenden Erfindung ist es, einen verbesserten VCSEL mit monolithisch integriertem Photodetektor anzugeben, der einfach herstellbar ist und eine ausreichend niedrige Laserimpedanz, niedriges Übersprechen und guten Kontrast gegen spontane Emission besitzt.

Diese Aufgabe wird mit dem optoelektronischen Bauelement mit den Merkmalen des Anspruches 1 gelöst. Ausgestaltungen ergeben sich aus den abhängigen Ansprüchen.

Das erfindungsgemäße Bauelement ist ein VCSEL mit einem Photodetektor, der in einem der als Resonatorspiegel vorgesehenen DBR-Gitter integriert ist, so dass keine mechanische Justage einer externen Monitordiode erforderlich ist. Zwischen den DBR-Reflektoren befindet sich ein aktiver Bereich, der für Strahlungserzeugung vorgesehen ist. Die in dem Resonator erzeugte kohärente Strahlung wird an der Oberfläche des Bauelementes emittiert. Der Photodetektor in einem der DBR-Reflektoren umfaßt eine dünne absorbierende Schicht, die im Bereich eines Schwingungsbauches der stehenden Welle einer Lasermode angeordnet ist. Die Energiebandkante des Materials in dem dünnen absorbierenden Bereiches ist geringfügig niedriger gewählt als die Energie, die der Frequenz der emittierten Strahlung entspricht, um ein nicht reproduzierbares Ansprechen des Detektors zu verhindern, ohne jedoch den Anteil niedriger Energie der spontanen Emission zu absorbieren.

Laser und Photodetektor werden über eine gemeinsame Elektrode, vorzugsweise ein n-Kontakt, elektrisch angesteuert. Dieser Kontakt befindet sich auf einer Spacer-Schicht, die n-leitend dotiert ist mit einer ausreichenden Dotierstoffkonzentration, um einen niedrigen ohmschen Widerstand innerhalb der Schicht zu gewährleisten und auch für einen guten ohmschen Metall-Halbleiter-Kontakt zu sorgen. Diese Spacer-Schicht sorgt für niedrige Laserimpedanz und geringes elektrisches Übersprechen zwischen Laser und Photodetektor.

Vorzugsweise wird diese Spacer-Schicht oder eine weitere Schicht zwischen dem laseraktiven Bereich und dem Photodetektor so gewählt, dass das kohärente Licht durch diese Schicht hindurch tritt, aber der Anteil hoher Energie der spontanen Emission absorbiert wird, so dass damit für die spontane Emission ein Tiefpassfilter gebildet ist. Zusammen mit der Eigenschaft des dünnen absorbierenden Bereiches, einen Hochpassfilter zu bilden, ist so insgesamt ein Bandpassfilter gebildet, dessen Durchlassbereich um die Laserstrahlungsfrequenz herum liegt und so den Kontrast gegen spontane Emission weiter erhöht.

Es folgt eine genauere Beschreibung von Beispielen des erfindungsgemäßen Bauelementes anhand der Figuren 1 bis 5.
- Figur 1: zeigt einen Querschnitt durch ein Ausführungsbeispiel des Bauelementes.
- Figur 2: zeigt ein weiteres Ausführungsbeispiel.
- Figur 3: zeigt ein Ersatzschaltbild für die in den Figuren 1 und 2 dargestellten Bauelementstrukturen.
- Figur 4: zeigt ein Diagramm für eine Feldverteilung um die Spacer-Schicht.
- Figur 5: zeigt ein Energiebanddiagramm einer speziellen Ausführungsform.

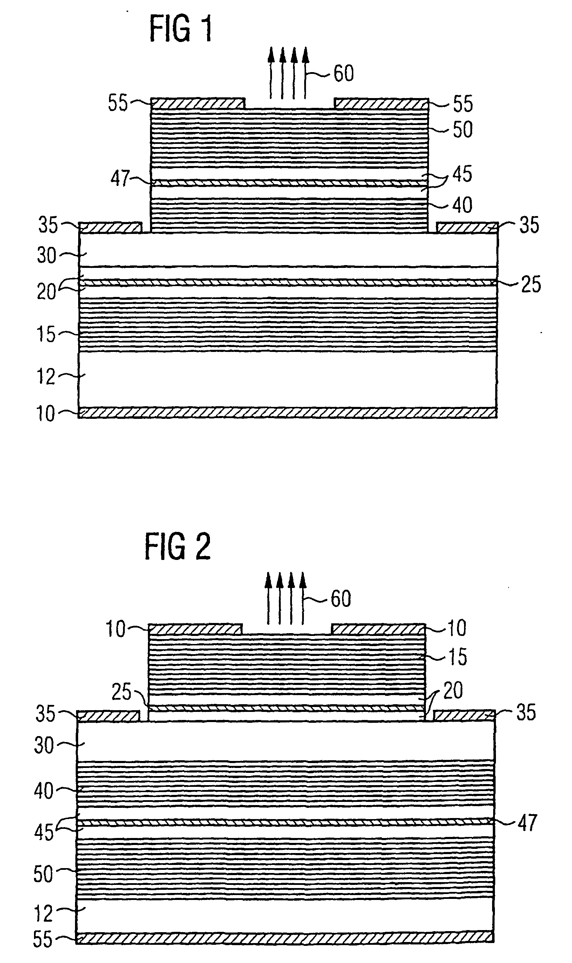

Figur 1 zeigt einen Querschnitt einer bevorzugten Ausführungsform des erfindungsgemäßen Bauelementes mit einem Photodetektor zwischen einem Substrat und dem strahlungserzeugenden aktiven Bereich, während Figur 2 einen entsprechenden Querschnitt für ein Bauelement zeigt, bei dem der Photodetektor auf der von dem Substrat abgewandten Seite des aktiven Bereiches angeordnet ist. Bei dem Ausführungsbeispiel nach Figur 1 befinden sich auf einem vorzugsweise p-leitend dotierten Substrat 12 mit einem Rückseitenkontakt 10 übereinander ein in diesem Beispiel p-leitend dotierter erster Anteil 15 eines unteren ersten DBR-Gitters, ein intrinsisch leitender Bereich 20 des Photodetektors mit einer darin angeordneten dünnen Absorptionsschicht 25, eine Spacer-Schicht 30, die hier hoch n-leitend dotiert ist, ein n-leitend dotierter zweiter Anteil 40 des ersten DBR-Gitters, ein laseraktiver Bereich 45 mit einer darin ausgebildeten aktiven Schicht 47 und ein p-leitend dotiertes oberes zweites DBR-Gitter. Der aktive Bereich 45, 47 ist vorzugsweise als SCH (Separate Confinement Heterostructure) ausgebildet. Auf der Spacer-Schicht 30 befindet sich in diesem Beispiel ein ringförmiger Kontakt 35, der rings um eine Mesa aus Halbleitermaterial angeordnet ist, in der sich der obere Anteil 40 des ersten DBR-Gitters, der aktive Bereich 45, 47 und das zweite DBR-Gitter 50 befinden.

Die Absorptionskante des Energiebandes ist in der absorbierenden Schicht 25 geringfügig niedriger gewählt als die Energie des kohärenten Lichtes der erzeugten Lasermode. Auf diese Weise kann die Strahlung der Lasermode sicher detektiert werden, ohne gleichzeitig den Anteil niedriger Energie in der spontanen Emission zu erfassen. Für eine Laserenergie von z.B. 1460 meV kann die Absorptionskante bei etwa 1450 meV gewählt werden. In diesem Beispiel ist die dünne Absorptionsschicht typisch etwa 7 nm dick und als InGaAs-Potentialtopf mit einem Indiumgehalt von wenigen Prozent ausgebildet. Bei der Festlegung der richtigen Absorptionskante sind der Einfluß von Excitonen und der Temperatur zu berücksichtigen. Die Absorptionskante kann z.B. mittels Transmissionsspektroskopie gemessen werden. Je geringer der Unterschied zwischen der effektiven Energiebandlücke und der Energie der Laserstrahlung ist, um so geringer ist der Anteil der absorbierten spontanen Emission im oberen Energiebereich und um so besser ist der Kontrast gegen die spontane Emission.

Die Spacer-Schicht 30 hat vorzugsweise eine Dicke von mehreren Wellenlängen der Laserstrahlung und ist vorzugsweise direkt über dem intrinsisch leitenden Bereich 20 des Photodetektors angeordnet. Die effektive Energiebandlücke der Spacer-Schicht 30 wird so gewählt, dass sie die kohärente Strahlung der Lasermode nicht absorbiert, aber den Anteil hoher Energie der spontanen Emission absorbiert.

Ein oberer ringförmiger p-Kontakt 55 vervollständigt das Bauelement. Grundsätzlich kann auch ein lichtdurchlässiger oberer Kontakt aufgebracht sein, der dann die gesamte Lichtaustrittsfläche bedeckt. Alternativ kann auch Lichtaustritt nach unten durch das Substrat 12 hindurch vorgesehen sein. Das Substrat ist dann entsprechend aus einem für die Emissionswellenlänge durchlässigen Halbleitermaterial gebildet. Außerdem sind auch andere Laserwellenlängen, z.B. 980 nm oder 1300 nm mit einem entsprechend gewählten Halbleitermaterial der dünnen Absorptionsschicht des Photodetektors möglich. Dieses Material ist geringfügig verschieden von dem Material der aktiven Schicht, weil ein etwas niedrigerer Energiebandabstand in der absorbierenden Schicht erforderlich ist als in der aktiven Schicht. Die Vorzeichen der Dotierung (n-leitend bzw. p-leitend) können vertauscht sein. Die in obiger Beschreibung angegebenen Vorzeichen stellen aber das bevorzugte Ausführungsbeispiel dar.

Die Monitorfunktion des Photodetektors hängt nicht von der Polarisationsrichtung oder den Eigenschaften der Transversalmoden der VCSEL ab. Eine Variation des aktiven Bereiches oder der Form der Mesastruktur mit dem darin vorhandenen aktiven Bereich liegt im Rahmen der Erfindung.

In einer anderen bevorzugten Ausführungsform entsprechend Figur 2 sind die Positionen der SCH-Struktur 45 mit der aktiven Schicht 47 und des Photodetektorbereiches mit der intrinsisch leitenden Schicht 20 und der dünnen Absorptionsschicht 25 miteinander vertauscht. Der Photodetektor befindet sich hier oberhalb der dicken n-dotierten Spacer-Schicht 30. Der aktive Bereich mit der aktiven Schicht 47 befindet sich zwischen einem p-leitend dotierten ersten Anteil 50 und einem n-leitend dotierten zweiten Teil 40 eines unteren DBR-Gitters zwischen der Spacer-Schicht 30 und dem Substrat 12. Auf der Spacer-Schicht 30 ist auch hier ein n-Kontakt 35 aufgebracht. Der Photodetektor 20, 25 ist innerhalb der streifenförmigen Mesastruktur angeordnet, und zwar unterhalb eines oberen p-leitend dotierten DBR-Gitters 15. Die Detektoranode wird durch einen p-Kontakt 10 auf der Oberseite gebildet. Für diesen Kontakt gilt sinngemäß das, was zu dem Ausführungsbeispiel gemäß Figur 1 erläutert wurde.

Ein wesentlicher Vorteil des erfindungsgemäßen Bauelementes liegt darin, daß der effektive Photodetektorbereich verringert werden kann, was einen besseren Kontrast gegen spontane Emission und eine geringere Photodetektorkapazität liefert. Damit erreicht man eine hohe Detektorgeschwindigkeit. Geringe Laserkapazitäten können erreicht werden, indem man die für den Laser vorgesehene Struktur innerhalb des Ausführungsbeispieles gemäß Figur 2 mit möglichst geringen Abmessungen ausbildet, die allerdings größer sein müssen als die Abmessungen der Mesa des Photodetektors. Für die Herstellung werden bevorzugt Trockenätzverfahren angewendet.

Der auf der Spacer-Schicht 30 aufgebrachte n-Kontakt 35 muß nicht ein ringförmiger Kontakt sein. Wegen des geringen ohmschen Widerstandes der ausreichend hoch n-leitend dotierten Spacer-Schicht 30 ist auch eine asymmetrische seitliche Ladungsträgerinjektion ohne Verschlechterung der Lasereigenschaften möglich. Der Kontakt 35 kann daher auf einer seitlichen Oberseite der Spacer-Schicht 30 außerhalb des Bereiches der Mesa mit dem Photodetektor aufgebracht sein. Dann kann der untere Teil der Struktur mit dem laseraktiven Bereich auch als Mesa mit fast ebenso geringen Abmessungen wie die Abmessungen des Photodetektorbereiches ausgebildet sein.

Die übrigen Eigenschaften der beschriebenen Ausführungsbeispiele können entsprechend herkömmlichen VCSEL ausgebildet sein. Gold-Metall-Legierungen sind bevorzugte Kontaktmaterialien. Bevor das Metall auf die Halbleiteroberseite aufgebracht wird, wird diese von evtl. vorhandenen Oxiden befreit. Um gute Metall-Halbleiter-Kontakte zu erreichen auch im Falle stark variierender Mischkristallzusammensetzungen, was z.B. bei den DBR-Gittern der Fall ist, müssen auch Inhomogenitäten der Ätztiefe berücksichtigt werden. Diese Inhomogenitäten variieren mit dem Materialsystem, das verwendet wird, und der Art des Ätzprozesses (Trockenätzen, Nassätzen), hängen aber hauptsächlich von der Gleichmäßigkeit der epitaktisch gewachsenen Schichten ab. Im Fall von AlGaAs und Schwefelsäure und Wasserstoffperoxid in wäßriger Lösung als naßchemischer Ätzlösung erreichen typische Inhomogenitäten Abweichungen von ± 20 nm pro Mikrometer Ätztiefe. Es ist schwierig, gute und stabile ohmsche Kontakte auf Schichten mit hohem oder variierendem Aluminiumgehalt zu erreichen. Erfindungsgemäß wird das Bauelement daher mit einer dicken, homogenen und hoch n-leitend dotierten Halbleiterschicht als Spacer-Schicht 30 versehen. Bei dieser dicken Spacer-Schicht 30 sind Toleranzen der Ätztiefe akzeptabel; außerdem dient die Schicht als gemeinsame niederohmige Kontaktschicht für Laser und Photodetektor.

Eine n-dotierte Spacer-Schicht angrenzend an den Photodetektor wie in dem erfindungsgemäßen Bauelement hat verschiedene Vorteile. Parasitäre Lichtabsorption durch freie Ladungsträger ist üblicherweise in n-leitend dotiertem Halbleitermaterial niedriger als in p-leitend dotiertem (zumindest für die Mehrzahl üblicherweise verwendeter Halbleitermaterialien). Z. B. ist im Materialsystem von AlGaAs bei 850 nm Wellenlänge die optische Absorption in p-dotiertem Material ungefähr um einen Faktor von 2,5 bis 3 höher als in n-dotiertem Material derselben Dotierstoffkonzentration. Ein weiterer Vorteil bei der Verwendung einer n-dotierten Spacer-Schicht angrenzend an den Photodetektor ist der entsprechend niedrigere ohmsche Widerstand, der mit n-leitendem Halbleitermaterial im Vergleich zu p-leitendem Material erreicht wird. Das liegt an der höheren Beweglichkeit der Elektronen als der Löcher, z.B. um einen Faktor von etwa 20 in AlGaAs. Wenn ein pin-Photodetektor ohne zusätzlichen Tunnelübergang gefordert ist (d.h. ohne p⁺-n⁺-Übergang, der sich bei Polung in Gegenrichtung wie ein ohmscher Widerstand verhält), wird das DBR-Gitter auf ein p⁺-Substrat, vorzugsweise unter Verwendung einer Pufferschicht, die bei niedriger Temperatur hergestellt wird, aufgewachsen. Statt dessen kann ein konventioneller npn-Bipolarphototransistor mit Basis auf floatendem Potential und gradierter Energiebandlücke (HBPT) als Photodetektor verwendet werden, wobei an den Photodetektor eine zusätzliche Spannung angelegt wird. Dieses Bauelement kann auf einem n-Substrat aufgewachsen werden. Alternativ kann auch eine Doppeldiodenstruktur mit gemeinsamer Anode (npn) oder gemeinsamem Tunnelkontakt (npp⁺n⁺np) als Detektor verwendet werden, wobei beide Photodioden zu Kompensationszwecken unterschiedliche Absorptionseigenschaften aufweisen können. So ist durch interne oder externe Überlagerung der Photoströme eine Erhöhung des Kontrastverhältnisses möglich, wenn die detektierende Schicht (25) der ersten Photodiode in einem Schwingungsbauch und die detektierende Schicht der zweiten Photodiode im Schwingungsknoten der stehenden Welle liegt und beide Photoströme voneinander abgezogen werden.

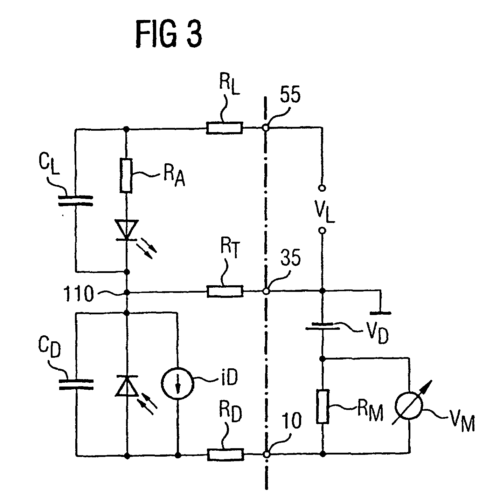

In Figur 3 ist ein Ersatzschaltbild für eine grundsätzliche Struktur des erfindungsgemäßen Bauelementes mit integriertem pin-Photodetektor entsprechend Figur 1 oder 2 dargestellt. Der obere Teil dieses Diagramms in Figur 3 entspricht der intrinsischen Laserimpedanz, die in erster Linie durch den ohmschen Laserwiderstand R_{A} im Betrieb des Lasers parallel zu der effektiven Laserkapazität C_{L} bestimmt wird. Der untere Teil des Diagramms gibt die Kapazität C_{D} des Photodetektors parallel zur Stromquelle i_{D} für den Photostrom wieder. Der gemeinsame n-Kontakt hat einen Reihenwiderstand R_{T}, der durch den lateralen ohmschen Widerstand in der dicken n-dotierten Spacer-Schicht 30 bestimmt wird. Wesentliche dynamische Größen sind die RC-Zeitkonstanten τ_{L}, τ_{D} des Lasers bzw. des Photodetektors. Die letztere wird beeinflusst durch den externen Messwiderstand R_{M} und ist gleich τ_{D} = C_{D} (R_{D} + R_{T} + R_{M}). Bei kleinen vorhandenen Photodetektorbereichen kann eine kleine Photodetektorkapazität erzielt werden, aber in diesem Fall ist der innere Widerstand R_{D} größer (R_{D} = const/C_{D}), was einen zusätzlichen parasitären Spannungsabfall verursacht, der die lineare Eigenschaft des Photodetektors bei Betrieb mit kleinen oder verschwindend geringen Detektorspannungen V_{D} verschlechtern kann.

Die intrinsische RC-Zeitkonstante für den Laser ist gegeben durch τ_{L} = R_{A} C_{L}. Abgesehen davon und von anderen intrinsischen Größen, wie z.B. die Laserresonanzfrequenz und die Photonenlebensdauer, ist die Gesamtlaserimpedanz (R_{L} + R_{A}) / (C_{L} + R_{T}) eine sehr wichtige Größe, die parallel zu Kapazitäten einer Treiberschaltung oder eines modularen Aufbaus auftritt und so klein wie möglich sein sollte, um die Verwendung billiger Lasertreiberschaltungen zu ermöglichen.

Im Falle niedriger Frequenzen oder verschwindendem C_{D} gibt die Beziehung R_{T}(C_{L} + R_{T}) / (R_{L} + R_{A}) den Anteil der Lasermodulationsspannung wieder (parasitäre Wechselspannung am Knoten 110), der parasitär auch am Photodetektor anliegt. Wenn ein Photodetektor mit einer stark spannungsabhängigen Empfindlichkeit verwendet wird, wie z.B. ein Phototransistor, sind ein kleiner Wert R_{T} und hohe anliegende Photodetektorspannungen zu bevorzugen.

Für elektrisches Übersprechen zwischen dem Laser und dem Photodetektor bei hohen Frequenzen kann eine Kopplungszeitkonstante durch τ_{coup} = R_{T} C_{D} definiert werden. Bei einer Modulationsfrequenz f = 1 / (2π τ_{coup}) wird etwa die Hälfte der parasitären Wechselspannung am Knoten 110 in den Widerstand R_{D} + R_{M} über die Photodetektorkapazität gekoppelt, und zwar dem Photostromsignal überlagert. Um die hochfrequenten Komponenten des Photostromes zu erfassen, wird ein kleiner Wert von τ_{D} benötigt. Aber der Spannungsabfall, der durch den Photostrom über die Widerstände R_{D} + R_{M} hervorgerufen wird, muß immer noch groß sein im Vergleich zu besagter parasitärer Wechselspannung, um das Übersprechen zu minimieren. Daher soll der laterale Widerstand R_{T} zur Erzeugung guter Modulationseigenschaften des Lasers und guter Hochfrequenzeigenschaften des Photodetektorsignales so gering wie möglich sein, auch wenn als Photodetektor eine pin-Photodiode hoher Qualität verwendet wird.

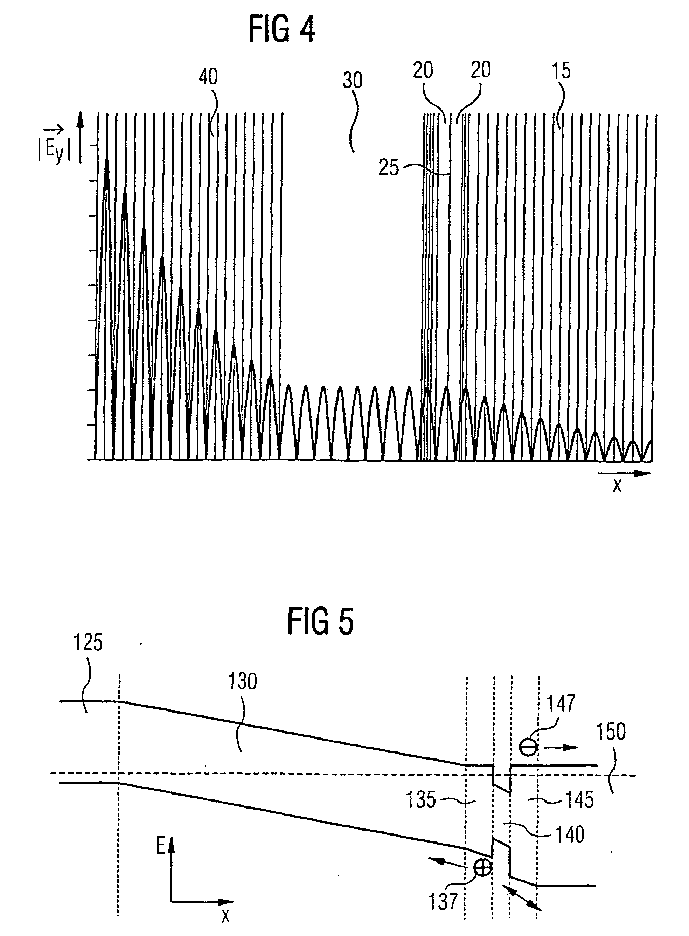

Die optische Dicke des Photodetektorbereiches einschließlich der dicken Spacer-Schicht im Vergleich zu der Laserwellenlänge ist ebenfalls eine wichtige Größe. Sie bestimmt, ob der Photodetektor in dem Resonator die Laserintensität resonant beeinflusst oder nicht. Ein beliebiger Photodetektor kann eine dünne Absorptionsschicht an einer bestimmten Stelle innerhalb des Musters der stehenden Welle des kohärenten Lichtes aufweisen. Eine erste Verbesserung der Detektionsempfindlichkeit kann erzielt werden, indem nur das Maximum der Intensitätsverteilung erfasst wird. Diese Verstärkung kann mittels des sogenannten Confinement-Faktors quantifiziert werden. Eine weitere Verstärkung ist möglich, wenn die Position des Detektors in den DBR-Gittern in der Nähe des aktiven Bereiches gewählt wird. In Figur 4 ist die berechnete Feldverteilung für die kohärente Strahlung für eine spezielle Ausführungsform entsprechend Figur 1 in der Nachbarschaft der dicken Spacer-Schicht dargestellt.

Um zu vermeiden, dass die Spacer-Schicht 30 eine unbeabsichtigte Resonanz in Bezug auf die Laserwellenlänge besitzt, sollte die Dicke der Spacer-Schicht in etwa ein ungerades Vielfaches eines Viertels der Laserwellenlänge betragen. Eine nicht resonante Spacer-Schicht hat den Vorteil einer geringen Abhängigkeit der Photodetektoreigenschaften, wie z.B. des Ansprechverhaltens, von der genauen Dicke der Epitaxieschicht. Da bei dem erfindungsgemäßen Bauelement die Spacer-Schicht relativ dick ist im Vergleich zur Laserwellenlänge, ist eine genaue Einstellung der Dicke der Schicht sehr wichtig. Beim epitaktischen Aufwachsen der Schichten kann die Genauigkeit der Schichtdicke durch In-situ-Kontrolle verbessert werden. Die notwendige absolute Genauigkeit der Schichtdicke ist durch eine Schichtdicke bestimmt, die wesentlich unter einer Viertelwellenlänge liegt. Bei einem speziellen Ausführungsbeispiel, wie es oben beschrieben wurde, führt eine Abweichung von etwa ± 13 nm von einer Gesamtdicke von 1,3 µm der Spacer-Schicht zu einer Streuung von etwa ± 5% in der Photodetektorempfindlichkeit.

Figur 5 zeigt ein vereinfachtes Energiebanddiagramm, für eine spezielle Ausführungsform mit gradierter Dotierung und Energiebandlücke in der absorbierenden Schicht und den angrenzenden Schichten. Auf diese Weise kann die Absorption innerhalb der dünnen Absorptionsschicht als Folge der Dotierstoffkonzentration reduziert werden; und gleichzeitig kann parasitäre Rekombination der Ladungsträger vermieden werden, was zu niedrigeren Empfindlichkeiten des Detektors und höherem differentiellem Wirkungsgrad des Lasers ohne Beeinträchtigung des Kontrastes gegen spontane Emission führt. Der pin-Photodetektor umfaßt einen p-dotierten Bereich 125, eine intrinsisch leitend dotierte Schicht 130, mit der die Photodetektorkapazität vermindert wird, und eine n-dotierte Schicht 150. Im Gegensatz zu herkömmlichen Potentialtopf-pin-Dioden, die an sich bekannt sind, ist hier die absorbierende Schicht 41 hoch n-leitend dotiert und in hoch n-leitend dotierte Schichten 135 und 145 eingebettet, um die optische Absorption zu vermindern. Z.B. ist für eine Reduktion der optischen Absorption um mehr als einen Faktor 3 eine Dotierstoffkonzentration von mehr als 2x10¹⁸ cm⁻³ in InGaAs-Potentialtöpfen mit einem Indiumgehalt von wenigen Prozent erforderlich. Der Photostrom muss aus der hoch dotierten Zone geleitet werden, um zu vermeiden, dass die Löcher 137 mit den Elektronen 147 rekombinieren. In dieser Ausführungsform des erfindungsgemäßen Bauelementes haben die angrenzenden hoch dotierten Schichten ein Energiebandgrading, das zu einer Reduktion der Energiebandlücke und damit in der Richtung zu der intrinsisch dotierten Schicht 130 zu einer Reduktion der Differenz zwischen dem Valenzband und dem Fermi-Niveau führt. Zusätzlich können asymmetrische Barrieren für die dünne absorbierende Schicht 140 verwendet werden, und zwar mit einer niedrigeren Barrierenhöhe in Richtung zur Schicht 135, wie in der Figur 5 dargestellt.

Eine weitere Möglichkeit besteht darin, die Elektronendichte in der dünnen absorbierenden Schicht 140 dadurch zu ändern, dass eine Photodetektorspannung angelegt wird in der Weise, dass die Verarmungszone in die absorbierende Schicht hinein reicht. Auf diese Weise kann der Absorptionsgrad durch die angelegte Spannung moduliert werden. Mittels geeigneter Anpassung der Dotierstoffkonzentration und der Dicke der Schicht 135 sowie der Schicht 130 können die Modulationstiefe und die DC-Vorspannung geändert werden.

## Patentansprüche

1. Optoelektronisches Bauelement als VCSEL mit einer für Strahlungserzeugung vorgesehenen aktiven Schicht (47) zwischen DBR-Gittern (15; 40, 50) als Reflektoren und einem mit einer strahlungsabsorbierenden Schicht (25) versehenen Photodetektor innerhalb eines der DBR-Gitter, wobei die strahlungsabsorbierende Schicht (25) so angeordnet ist, dass sie mit einem Schwingungsbauch einer Lasermode der erzeugten Strahlung überlappt,
**dadurch gekennzeichnet, dass**
die strahlungsabsorbierende Schicht (25) innerhalb eines intrinsisch leitenden Bereiches (20) angeordnet ist,
eine hoch dotierte Spacer-Schicht (30) zwischen der aktiven Schicht (47) und der absorbierenden Schicht (25) vorhanden ist und
die Spacer-Schicht (30) eine Dicke von mehreren Wellenlängen der Laserstrahlung besitzt und angrenzend an den intrinsisch leitenden Bereich (20) angeordnet ist.

2. Bauelement nach Anspruch 1,
bei dem die strahlungsabsorbierende Schicht (25) eine Energiebandkante aufweist, die geringfügig niedriger ist als die Photonenenergie der Lasermode.

3. Bauelement nach Anspruch 1 oder 2,
bei dem der Photodetektor (20, 25) und die Spacer-Schicht (30) bezüglich der Lasermode eine nicht-resonante optische Dicke haben, so dass eine elektrische Feldverteilung der Strahlung innerhalb der DBR-Gitter (15; 40, 50) unverändert bleibt.

4. Bauelement nach einem der Ansprüche 1 bis 3,
bei dem die Spacer-Schicht (30) eine Energiebandkante aufweist, die geringfügig höher ist als die Photonenenergie der Lasermode.

5. Bauelement nach einem der Ansprüche 1 bis 4,
bei dem die Spacer-Schicht (30) hoch n-leitend dotiert ist und mindestens eine Halbleiterschicht an die absorbierende Schicht (25) angrenzt und hoch n-leitend dotiert ist.

6. Bauelement nach Anspruch 5,
bei dem mindestens eine an die absorbierende Schicht (25) angrenzende Halbleiterschicht eine Gradierung in der Energiebandlücke aufweist, so dass in einem zu der absorbierenden Schicht benachbarten Bereich die Energiebandlücke in Richtung zu der Spacer-Schicht (30) hin anwächst.

7. Bauelement nach Anspruch 5 oder 6,
bei dem die strahlungsabsorbierende Schicht (25) innerhalb einer Verarmungsschicht oder nahe an einem n-dotierten Randbereich einer Verarmungsschicht liegt und
Mittel vorhanden sind, mit denen eine elektrische Spannung angelegt werden kann, um die Absorption in der absorbierenden Schicht (25) zu verändern.

8. Bauelement nach einem der Ansprüche 1 bis 7,
bei dem der Photodetektor eine pin-Photodiode ist.

9. Bauelement nach einem der Ansprüche 1 bis 7,
bei dem der Photodetektor ein Phototransistor aus der Gruppe von bipolarem Phototransistor und heterobipolarem Phototransistor ist.

10. Bauelement nach einem der Ansprüche 1 bis 7,
bei dem der Photodetektor aus zwei Photodioden besteht, die eine gemeinsame Anode (npn) oder eine gemeinsame Kathode (pnp) aufweisen.

11. Bauelement nach einem der Ansprüche 1 bis 7,
bei dem der Photodetektor aus zwei Photodioden besteht, die einen gemeinsamen Tunnelkontakt (npp⁺n⁺np) aufweisen.

## Claims

1. Optoelectronic component as a VCSEL with an active layer (47) intended for radiation generation between DBR gratings (15; 40, 50) as reflectors and a photodetector provided with a radiation-absorbing layer (25) inside one of the DBR gratings, the radiation-absorbing layer (25) being arranged in such a way that it overlaps with an antinode of a laser mode of the generated radiation, **characterized in that** the radiation-absorbing layer (25) is arranged within an intrinsically conductive region (20),
there is a heavily doped spacer layer (30) between the active layer (47) and the absorbing layer (25) and
the spacer layer (30) has a thickness of several wavelengths of the laser radiation and is arranged adjacent to the intrinsically conductive region (20).

2. Component according to Claim 1, in which the radiation-absorbing layer (25) has an energy band edge that is slightly lower than the photon energy of the laser mode.

3. Component according to Claim 1 or 2, in which the photodetector (20, 25) and the spacer layer (30) have a nonresonant optical thickness with respect to the laser mode, so that an electric field distribution of the radiation inside the DBR gratings (15; 40, 50) remains unmodified.

4. Component according to one of Claims 1 to 3, in which the spacer layer (30) has an energy band edge that is slightly higher than the photon energy of the laser mode.

5. Component according to one of Claims 1 to 4, in which the spacer layer (30) is heavily doped with n-type conductivity, and at least one semiconductor layer adjoins the absorbing layer (25) and is heavily doped with n-type conductivity.

6. Component according to Claim 5, in which at least one semiconductor layer adjoining the absorbing layer (25) has a grading in the energy band gap, so that in a region neighbouring the absorbing layer, the energy band gap grows in the direction of the spacer layer (30).

7. Component according to Claim 5 or 6, in which the radiation-absorbing layer (25) lies inside a depletion layer or close to an n-doped edge region of a depletion layer, and there are means by which an electrical voltage can be applied in order to modify the absorption in the absorbing layer (25).

8. Component according to one of Claims 1 to 7, in which the photodetector is a pin photodiode.

9. Component according to one of Claims 1 to 7, in which the photodetector is a phototransistor from the group of bipolar phototransistors and heterobipolar phototransistors.

10. Component according to one of Claims 1 to 7, in which the photodetector consists of two photodiodes, which have a common anode (npn) or a common cathode (pnp).

11. Component according to one of Claims 1 to 7, in which the photodetector consists of two photodiodes, which have a common tunnel contact (npp⁺n⁺np).

## Revendications

1. Composant optoélectronique servant de VCSEL, ayant une couche active (47) prévue pour la production d'un rayonnement entre des réseaux DBR (15 ; 40, 50) servant de réflecteurs, et un photodétecteur, muni d'une couche (25) absorbant les rayonnements, à l'intérieur de l'un des réseaux DBR, la couche (25) absorbant les rayonnements étant disposée de façon à être en chevauchement avec un ventre de vibration d'un mode laser du rayonnement produit,
**caractérisé en ce que** la couche (25) absorbant les rayonnements est disposée à l'intérieur d'un domaine (20) à conduction intrinsèque,
qu'une couche d'espacement (30) fortement dopée est présente entre la couche active (47) et la couche absorbante (25), et
que la couche d'espacement (30) a une épaisseur de plusieurs longueurs d'onde du rayonnement laser et est disposée en étant contiguë au domaine à conduction intrinsèque (20).

2. Composant selon la revendication 1, dans lequel la couche (25) absorbant les rayonnements présente un bord de bande d'énergie, qui est un peu plus petit que l'énergie des photons du mode laser.

3. Composant selon la revendication 1 ou 2, dans lequel le photodétecteur (20, 25) et la couche d'espacement (30) ont, en ce qui concerne le mode laser, une épaisseur optique non résonante de telle sorte que la distribution du champ électrique du rayonnement reste inchangée à l'intérieur du réseau DBR (15 ; 40, 50).

4. Composant selon l'une des revendications 1 à 3, dans lequel la couche d'espacement (30) présente un bord de bande d'énergie qui est un peu plus élevé que l'énergie des photons du mode laser.

5. Composant selon l'une des revendications 1 à 4, dans lequel la couche d'espacement (30) est fortement dopée n, et au moins une couche semi-conductrice est contiguë à la couche absorbante (25) et est fortement dopée n.

6. Composant selon la revendication 5, dans lequel au moins une couche semi-conductrice contiguë à la couche absorbante (25) présente une gradation de la bande interdite, de telle sorte que, dans un domaine voisin de la couche absorbante, la bande interdite augmente dans la direction allant vers la couche d'espacement (30).

7. Composant selon la revendication 5 ou 6, dans lequel la couche (25) absorbant les rayonnements se trouve à l'intérieur d'une couche d'appauvrissement ou au voisinage d'un domaine marginal dopé n d'une couche d'appauvrissement, et que des moyens sont présents, à l'aide desquels il est possible d'appliquer une tension électrique pour modifier l'absorption dans la couche absorbante (25).

8. Composant selon l'une des revendications 1 à 7, dans lequel le photodétecteur est une photodiode PIN.

9. Composant selon l'une des revendications 1 à 7, dans lequel le photodétecteur est un phototransistor choisi dans l'ensemble comprenant les phototransistors bipolaires et les phototransistors hétérobipolaires.

10. Composant selon l'une des revendications 1 à 7, dans lequel le photodétecteur est constitué de deux photodiodes, qui présentent une anode commune (npn) ou une cathode commune (pnp).

11. Composant selon l'une des revendications 1 à 7, dans lequel le photodétecteur est constitué de deux photodiodes qui comportent un contact tunnel commun (npp⁺n⁺np).
